# EUROPEAN PATENT SPECIFICATION

(11) **EP 3 402 071 B1**
(45) Date of publication and mention of the grant of the patent: **25.11.2020**
(21) Application number: 17169933.3
(22) Date of filing: 08.05.2017
(51) Int. Cl.: H03F 3/30, H03F 3/21, H03F 3/50

(54) **CIRCUIT ARRANGEMENT**
SCHALTUNGSANORDNUNG
AGENCEMENT DE CIRCUIT

(43) Date of publication of application: 14.11.2018
(73) Proprietor: ams AG, 8141 Premstätten (AT)
(72) Inventor: Draghi, Paolo, 5656 AE Eindhoven (NL); Carbonini, Alessandro, 5656 AE Eindhoven (NL)
(74) Representative: Epping - Hermann - Fischer

(56) References cited:
- EP-A1- 2 945 286
- GB-A- 2 525 674
- US-A1- 2007 236 291
- US-A1- 2009 033 423
- US-A1- 2010 109 779
- US-A1- 2015 236 674

## Description

The invention relates to a circuit arrangement for level shifting.

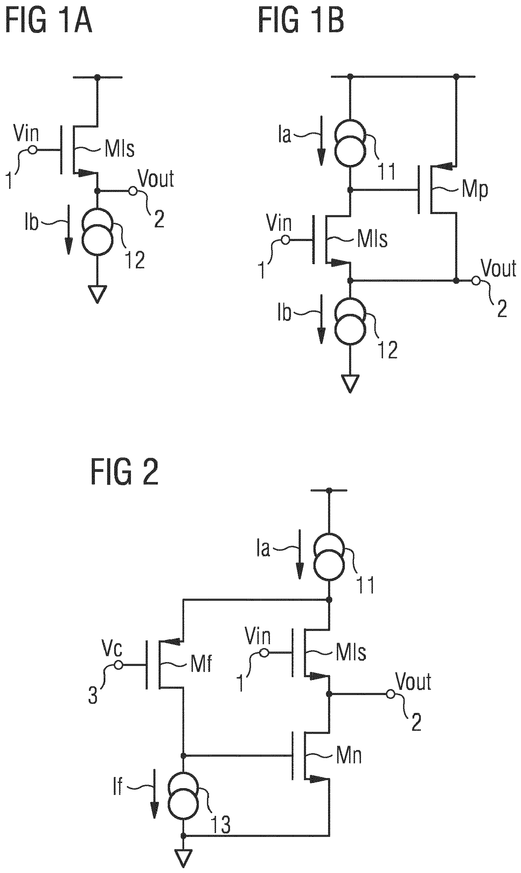

A level shift may be formed by a simple buffer structure including a MOSFET (metal oxide semiconductor field-effect transistor), wherein gate and source terminals of the MOSFET serve as the level shift's input and output. Figure 1a shows an exemplary embodiment of an NMOS-based level shift circuit arrangement including an NMOS (n-type metal-oxide semiconductor) Mls. Its drain terminal is connected to a reference potential and the source terminal is connected to a current source, also called current generator, 12 providing a current Ib. An input voltage Vin applied to input 1, which is a gate terminal, is transferred to an output voltage Vout provided at output 2, which is the source terminal. It should be mentioned that a PMOS-based level shift circuit arrangement may be formed in a similar way.

However, such a structure as described above may unfortunately have several drawbacks. The dynamic range at the output 2 is reduced by a voltage drop between the gate and source terminals. Moreover, there is a trade-off between output impedance and drive capability with power consumption. In other words, the output voltage may drop when a load connected to the output 2 draws current. The output impedance is due to a CMOS transconductance gm, and the current that can be delivered to the load is limited to a bias current, at least in one direction. On the contrary, the other direction may reach very high values. Besides swing limitations some methods for reducing the output impedance are known.

An improved circuit arrangement as shown in Figure 1b that is based on the above-mentioned arrangement includes a local feedback which comprises the level shift transistor Mls being an NMOS, a current source, also called current generator, 11 and a PMOS (p-type metal-oxide semiconductor) Mp. The current source 11 is connected to the drain terminal of the level shift NMOS Mls. The feedback loop includes the PMOS Mp; its source terminal is connected to the current source 11. Its gate and drain terminals are connected to the NMOS's drain and source terminals, respectively. A further current source 12 is connected to the NMOS's source terminal. It should be mentioned that a PMOS-based level shift circuit arrangement may be formed in a similar way.

Any voltage variation at the PMOS's gate terminal is transferred into a current across the PMOS Mp that goes back to the PMOS's gate terminal after having flown across the level shift NMOS Mls. The current across the level shift NMOS Mls is compared with a reference current Ia provided by the current source 11. As soon as the current that is supplied at the output 2 to the load plus the current Ib through the further current source 12 serving as a pulldown generator tends to be higher than the current Ia, the gate terminal of the PMOS Mp is pulled down to manage the current increase. This offers a large capability to pull the load up, but the arrangement shown in Figure 1a also offers the same feature. What makes the difference is the reduced output impedance in comparison with the arrangement shown in Figure 1a. As usual, adoption of the feedback loop tends to reduce the output impedance by a certain amount due to its loop gain.

An intuitive view for understanding the operation of the arrangement shown in Figure 1b is: Once the feedback loop operates, the current across the level shift NMOS Mls is equal to the current Ia provided by the current generator 11 regardless of the load. Thus, the voltage between the gate and source terminals Vgs of the NMOS Mls remains constant, which means that the output impedance is very small. Anyhow, this result is not always sufficient: First of all, it is necessary to keep the PMOS Mp alive to have the feedback loop closed. As soon as the load current plus the current Ib is smaller than the current Ia, the PMOS Mp goes off and the output impedance remains the same as the one of the arrangement shown in Figure 1a. Thus, the current Ib is preferably superior to the current Ia, which ensures a proper loop operation even when there is no DC load current. Moreover, the Ib has to be large because it indicates the maximum value by which the structure can sink from the load. This prevents slew rate limitations, but at the same time causes non-optimal current consumption.

An alternative approach would be that an NMOS is used to close the loop instead of a PMOS. Such an arrangement is shown in Figure 2. It includes a current source 11 providing a current Ia, a level shift NMOS Mls, a further NMOS Mn, a PMOS Mf and a further current source 13 providing a current If. A drain terminal of the level shift NMOS Mls is connected to the current source 11. A source terminal of the level shift NMOS Mls is connected to a drain terminal of the further NMOS Mn. A source terminal of the PMOS Mf is connected to the drain terminal of the level shift NMOS Mls. A drain terminal of the PMOS Mf is connected to the further current source 13 and a gate terminal of the further NMOS Mn. A supply voltage Vc is applied to a gate terminal of the PMOS Mf. In this arrangement, it is necessary to fold, via the PMOS Mf and the further current source 13, the signal current of the level shift NMOS Mls to reach the further NMOS's Mn gate terminal, but the concept of operation is the same: the feedback forces the level shift NMOS Mls to be crossed by the current Ia-If regardless of the load current and it is up to the further NMOS Mn to drive the exceeding current to the load. The folding element is provided merely for dynamic range reasons.

The pros and cons of this approach are similar to those for the aforementioned arrangement. There are reduced output impedance and large current drive capability in one sense only, except for that now it is pulling the output 2 down, not up like in the previous case.

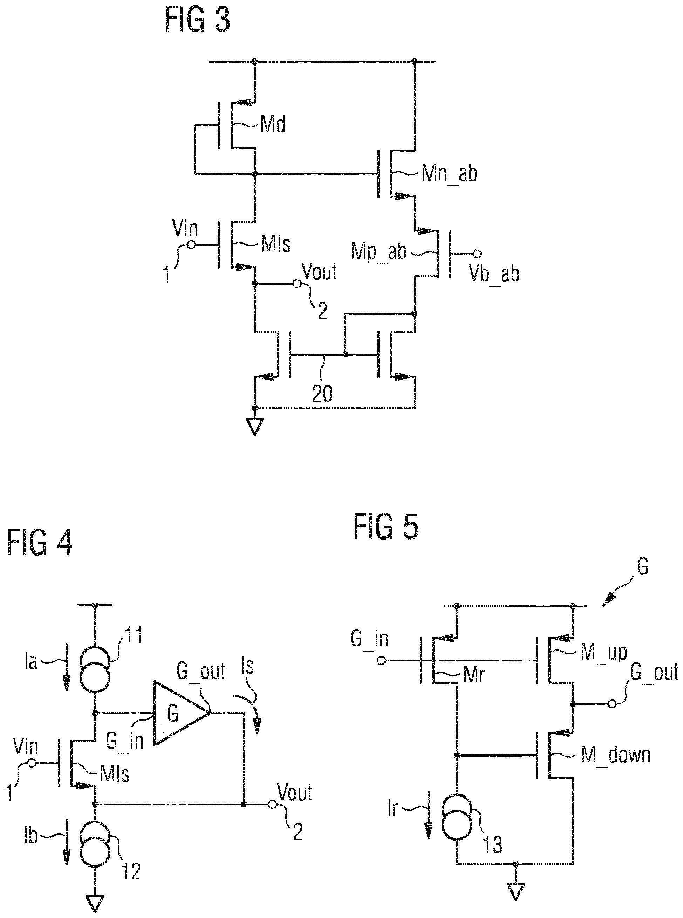

An alternative approach which has a good current drive capability is shown in Figure 3. The arrangement comprises a first circuit branch including a level shift NMOS Mls having a drain terminal that is connected to gate and drain terminals of a PMOS diode Md. Another circuit branch includes a further NMOS Mn_ab and a further PMOS Mp_ab, whose source terminals are connected. The gate and drain terminals of the PMOS diode Md are connected to a gate terminal of the further NMOS Mn_ab. The branches are coupled by a current mirror 20 comprising an NMOS pair.

Comparing the arrangements in Figures 1b and 3, the current generator 11 at the drain of the level shift NMOS Mls shown in Figure 1b has been replaced by the PMOS diode Md. In this way, the current from the level shift NMOS Mls is not limited and the low current drive capability for pullup is significantly improved. At the same time, the pull down capability is ensured by a closed feedback loop that, sensing the current across the added PMOS diode Md, is capable of varying the pull down current. A change in the voltage between gate and source terminals Vgs of the PMOS diode Md is sensed by a floating current generator formed by the transistor series Mp_ab and Mn_ab; a large current might be generated and mirrored by the NMOS pair 20 to the output 2. A voltage Vb_ab applied to the further PMOS's Mp_ab gate terminal is set in such a way that the bias current across the floating generator is kept small.

Unlike the arrangements previously shown, the arrangement shown in Figure 3 embodies a class AB amplifier approach, as both pullup and pulldown currents are largely boosted. However, there are still some drawbacks: First of all, the voltage supply swing is limited by the presence of three cascaded voltage drops between gate and source terminals Vgs to provide the necessary class AB structure for pulldown. Furthermore, the boost of the pulldown current is limited by the swing across the PMOS diode Md. This parameter is quite sensitive to temperature and process and can become too small to provide sufficient current increase versus the steady state value. Making the diode more resistive to increase the swing would frustrate the pullup capabilities, so a trade-off is needed. Moreover, the output impedance is not very small. In fact, as soon as the PMOS diode Md replaces the current generator Ia, it can be intuitively seen that the current across the level shift NMOS Mls is allowed to vary, unlike in the previous arrangements, and the voltage between the gate and source terminals Vgs of the level shift NMOS Mls is allowed to change, which may be confirmed by a mathematical analysis.

The arrangement in Figure 3 is not bad but also not excellent in drive capability, but poor in output impedance. The arrangements shown in Figures 1 and 2 provide a low output impedance, but suffer from a critical current drive capability.
US 2010/109779 A1 relates to a follower circuit, which can also be called a level shifter, comprising a current source, a MOSFET and an amplifier. The embodiment shown in Figure 1 of said document shows a hybrid configuration enabling low output impedance, high bandwidth and push-pull capability to reduce transient settling time. US 2007/236291 A1, GB 2 525 674 A and EP 2 945 286 A1 disclose similar source follower circuits that show a low impedance behaviour.
It is an object of the invention to provide an improved circuit arrangement.
The object is achieved by a circuit arrangement according to claim 1.

The gate terminal of the MOSFET, being preferably an NMOS, forms the input of the level shift stage. The drain terminal serves as a summing node of constant currents which do not depend on a DC voltage at the gate terminal. In this way the channel current of the MOSFET is constant versus the input signal. The drain terminal coupled to the current source may be connected to the amplifier having pullup and pulldown capabilities largely superior to its biasing current value. The output terminal of the amplifier is shorted to the source terminal of the MOSFET, which corresponds to the output of the level shift stage as well.

The scope of the invention is to provide class AB capability along with a very small output impedance to circumvent the problems of the previously described arrangements. Simple common source devices, e.g. a PMOS for Figure 1b and an NMOS for Figure 2, have drive capability in one sense only and are not suitable to ensure a class AB approach.

The push-pull amplifier allows to have constant or, better, zero input current and class AB properties. In this way the MOSFET would be always crossed by the same current, i.e. it guarantees very low output impedance. The push-pull or, preferably, class AB property of the amplifying stage would be directly brought to the proposed level shift. These two features are new and improve the performance of the level shift circuit arrangement.

The circuit arrangement may further comprise a second current source connected to the source terminal.

In a preferred embodiment the amplifier stage is a totem pole including a first transistor and a second transistor in a series arrangement. The drain terminal of the MOSFET is loaded directly by the input gate of the totem pole itself plus the first current source. The amplifier comprises a first circuit branch comprising the first and second transistors, a drain terminal of the first transistor being coupled to a source terminal of the second transistor. A second circuit branch is connected in parallel to the first circuit branch. The second branch comprises a third transistor and a third current source connected to a drain terminal of the third transistor and a gate terminal of the second transistor by a same terminal. The input terminal of the amplifier is connected to gate terminals of the first and third transistors. The output terminal is connected to the source terminal of the second transistor. The first, second, and third transistors are PMOS.

Alternatively, the drain node is the sum of a similar current generator and a folding or cascading MOSFET element source whose drain is driven by a constant current and makes the input of the totem pole stage. The amplifier comprises a first circuit branch comprising a first transistor and a second transistor, a source terminal of the first transistor being coupled to a drain terminal of the second transistor. A second circuit branch is connected in parallel to the first circuit branch. The second circuit branch comprises a third transistor and a third current source being connected to a drain terminal of the third transistor and a gate terminal of the first transistor by a same terminal. A third circuit branch comprises a fourth current source and a fourth transistor, a drain terminal of the fourth transistor being connected to the fourth current source and the gate terminals of the second and third transistors. The input terminal of the amplifier is connected to a source terminal of the fourth transistor. The output terminal is connected to the source terminal of the first amplifier. The first, second, and third transistors are NMOS, the fourth one is a PMOS.

In a second preferred embodiment the drain terminal of the level shift MOSFET is loaded by a MOSFET which mirrors the current into a fixed generator to ensure a constant channel current. The mirror output and the current generator summing node is the input of a push-pull stage that has an output shorted to the level shift output. The amplifier comprises a push-pull stage including two complementary transistors. A first circuit branch comprises the two complementary transistors, which are a first and a second transistor, the output terminal being connected in-between. A second branch comprises two further complementary transistors, which are a third transistor and a fourth transistor, being coupled to a third current source. A drain terminal of the third transistor is connected to gate terminals of the third and first transistors and the input terminal. A drain terminal of the fourth transistor is connected to gate terminals of the fourth and second transistors. The source terminals of the first transistor, being an NMOS, and the second transistor, being a PMOS, are connected. The source terminals of the third transistor, being an NMOS, and the fourth transistor, being a PMOS, are connected. A current mirror has first and second mirror transistors, the first mirror transistor, which is connected as a diode, forming the first current source, the second mirror transistor being connected to the input terminal, which is the input of the amplifier. The first and second mirror transistors and the third current source provide equal or nearly equal currents.

Non-limiting, exemplary embodiments of the invention will now be described with reference to the accompanying drawings, in which:
- Figures 1a, 1b, 2 and 3: show examples of level shift circuit arrangements.
- Figure 4: shows a conceptual architecture of a level shift circuit arrangement.
- Figure 5: shows an example of an amplifier.
- Figure 6: shows an example of a level shift circuit arrangement including the amplifier of Figure 5.
- Figure 7: shows an embodiment of a level shift circuit arrangement.
- Figures 8a and 8b: show output voltages Vout shown in Figures 2 and 8 versus time.
- Figure 9: illustrates load regulation of the examples in Figures 2 and 8.
- Figure 10: shows an example of an amplifier.
- Figure 11: shows an example of a level shift circuit arrangement including the amplifier of Figure 10.

Figures 1a, 1b, 2 and 3 have already been described above in connection with the technical background.

Figure 4 shows a conceptual architecture of an example of a level shift circuit arrangement. It includes a level shift NMOS Mls having gate, source and drain terminals. The circuit arrangement further comprises a first current source 11 and a second current source 12 providing first and second currents Ia and Ib and being connected to the drain and source terminals of the level shift NMOS Mls, respectively. A current source may be also called a current generator. An input terminal G in of a push-pull amplifier G is coupled to the first current source 11; in this example the input terminal G in is connected to the first current source 11 and the drain terminal. An output terminal G_out of the push-pull amplifier G providing an output current Is is connected to the source terminal. Circuit input 1, to which an input voltage Vin is applied, and circuit output 2, which provides an output voltage Vout, are connected to the gate terminal and the source terminal of the level shift NMOS Mls, respectively.

The push-pull amplifier G comprises usually two amplifying components, one amplifying positive signal portions and one amplifying negative signal portions. Preferably, the push-pull amplifier is a class AB amplifier wherein both components act as mentioned above and are also allowed to conduct at the same time around the waveforms crossover point eliminating crossover distortion problems. A class AB amplifier may provide a good compromise between linearity and power consumption. It may employ two output transistors.

A bias current is injected into the drain terminal of the level shift NMOS Mls and a feedback loop takes this node as an input and, by means of a transconductor stage, that is the push-pull amplifier G, it drives the circuit output 2. The output impedance is low. The push-pull amplifier G has constant or, better, zero input current and class AB properties. In this way, the level shift NMOS Mls would be always crossed by the same current, which guarantees very low output impedance. The class AB property of the amplifier stage would be directly brought to the proposed level shift.

Figure 5 shows an example of the amplifier G. It can be chosen as a classic totem pole approach. The amplifier G comprises a totem pole circuit including a first transistor M_up and a second transistor M _down; one transistor drives the output high while the other transistor connected below pulls the output terminal G_out low.

The totem pole amplifier G comprises a first circuit branch including the first and second transistors M_up, M_down, both being PMOS. A drain terminal of the first transistor M_up is coupled to a source terminal of the second transistor M_down. A second circuit branch is connected in parallel to the first circuit branch. The second circuit branch comprises a third transistor Mr, being a PMOS, and a third current source 13 providing a current Ir and being connected to a drain terminal of the third transistor Mr and the gate terminal of the second transistor M_down by one terminal. The other terminal is connected to the second transistor's M_down drain terminal. The input terminal G_in of the amplifier G is connected to gate terminals of the first and third transistors M_up, Mr. The output terminal G_out is connected to the source terminal of the second amplifier M_down. The first, second, and third transistors M_up, M_down, Mr are PMOS.

The arrangement described above has an input which is a common source device M_up and a further matched branch to obtain drive capability complementary to the one of the common source.

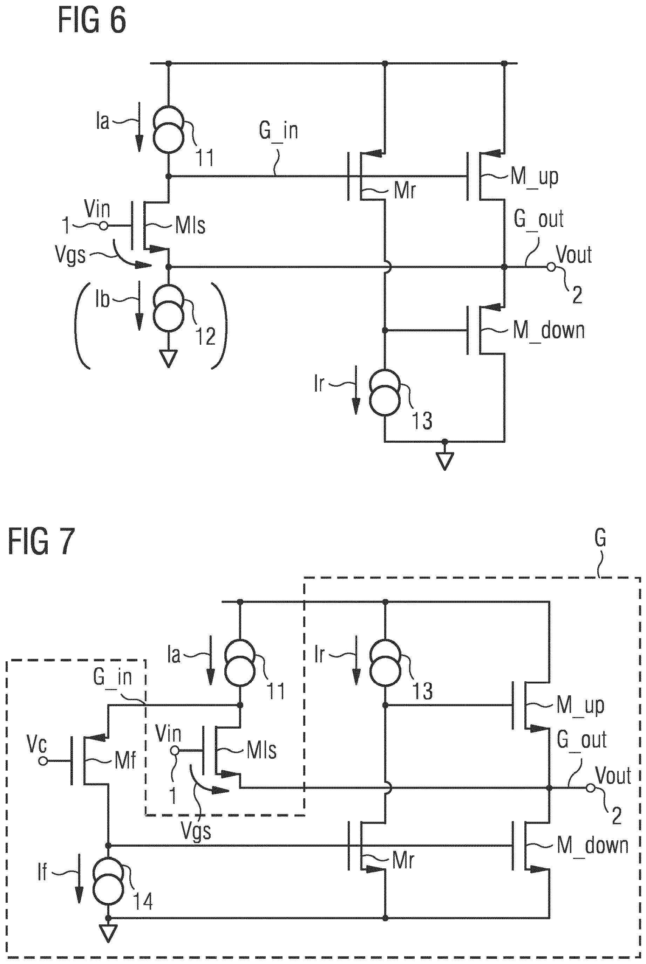

Figure 6 shows the amplifier according to Figure 5 inserted in the circuit arrangement according Figure 4, thereby forming a totem-pole-based class AB level shift circuit arrangement. The input terminal G_in of the amplifier G is connected to the level shift NMOS's Mls drain terminal. The output terminal G_out also serves as the circuit output 2.

The amplifier's input terminal current is zero so that the voltage between the gate and source terminals Vgs of the level shift NMOS Mls is constant. The second current source 12 can be omitted (indicated by the brackets) as the second transistor M_down may easily replace it and take over its function. Unfortunately the dynamic range at the circuit output 2 is made worse by the second transistor M_down, which needs an additional gate-source voltage Vgs room. The dynamic range of the output voltage Vout corresponds to a supply voltage minus two gate-source voltage drops, one caused by each of the first and second transistors M_up and M_down.

Figure 7 shows an embodiment that is complementary to the totem pole approach examples of Figures 5 and 6.

Amplifier G in Figure 7 is indicated by a dashed line. The amplifier G comprises a first circuit branch including first and second transistors M_up, M _down, both being NMOS. A source terminal of the first transistor M_up is connected to a drain terminal of the second transistor M _down. A second circuit branch is connected in parallel to the first circuit branch. The second circuit branch comprises a third transistor Mr, being an NMOS, and a third current source providing a current Ir and connected to a drain terminal of the third transistor Mr and a gate terminal of the first transistor M_up by one terminal. The other one is connected to a drain terminal of the first transistor M_up. A third circuit branch comprises a fourth current source 14 providing a current If and a fourth transistor Mf, being a PMOS. The fourth current source 14 is connected to a drain terminal of the fourth transistor Mf and the gate terminals of the second and third transistors M _down, Mr by one terminal. The other one is connected to a source terminal of the third transistor Mr. The amplifier input G_in is connected to a source terminal of the fourth transistor Mf and connected with the level shift NMOS's Mls drain terminal. The amplifier output G_out is connected to the source terminal of the first transistor M_up and is connected with the level shift NMOS's Mls source terminal. The level shift NMOS Mls and the current source Ia are coupled in the same manner as described in connection with Figure 4. Nevertheless, there is no need for a second current source 12 for the same reasons as mentioned above.

The totem-pole-based class AB level shift circuit arrangement of Figure 7 shows the preferred embodiment of the totem-pole-based approach. Since the first, second, and third transistors M_up, M_down, Mr are NMOS, it is necessary to add the folding means, which are the fourth transistor Mf, being a PMOS, and the fourth current source 14.

The output dynamic range is improved in comparison to the arrangement shown in Figure 6 since the dynamic range of the output voltage Vout corresponds to the supply voltage minus only one gate-source voltage drop. The dynamic range is comparable with the dynamic ranges of conventional approaches. The arrangement in Figure 7 offers the same dynamic range as the level shift NMOS Mls as a stand-alone block. At the same time, a large load current in both directions is delivered by the first and second transistors M_down and M_up with small variation at the gate terminal of the second transistor M _down. In this way, both the current If is not altered as soon as its current source has high impedance and the drain voltage for the level shift NMOS Mls remains the same thanks to the cascoding effect caused by the fourth transistor Mf. This ensures that the voltage between gate and source terminals Vgs of the level shift NMOS Mls remains constant at any load, which causes a very low output impedance. This arrangement is the preferred embodiment. Nevertheless, the dual counterpart with a level shift MOSFET Mls as a PMOS transistor is valid as well and can be built in a straightforward way.

The improvement of the embodiment shown in Figure 7 over the conventional one shown in Figure 2 is illustrated by the following measurement curves.

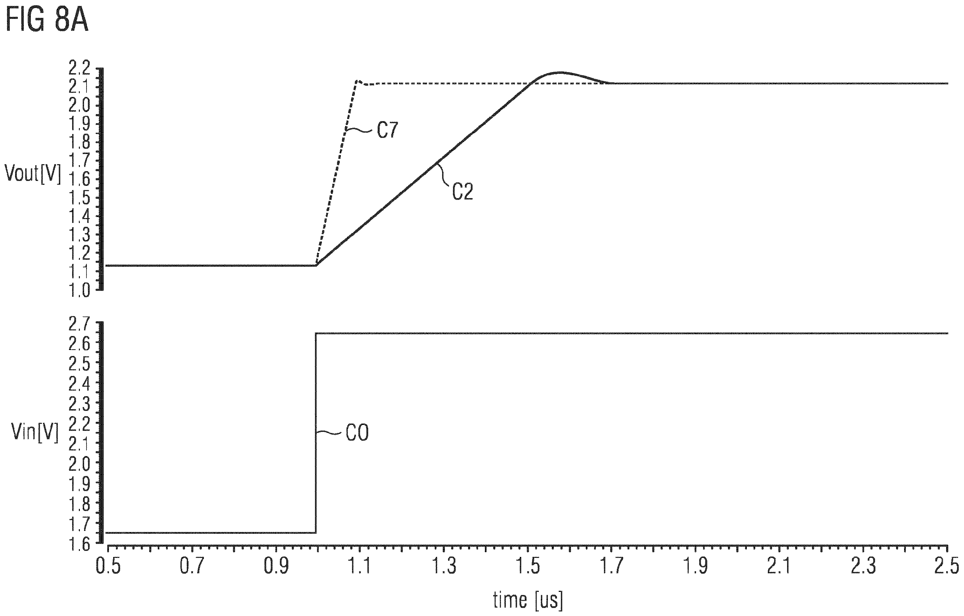

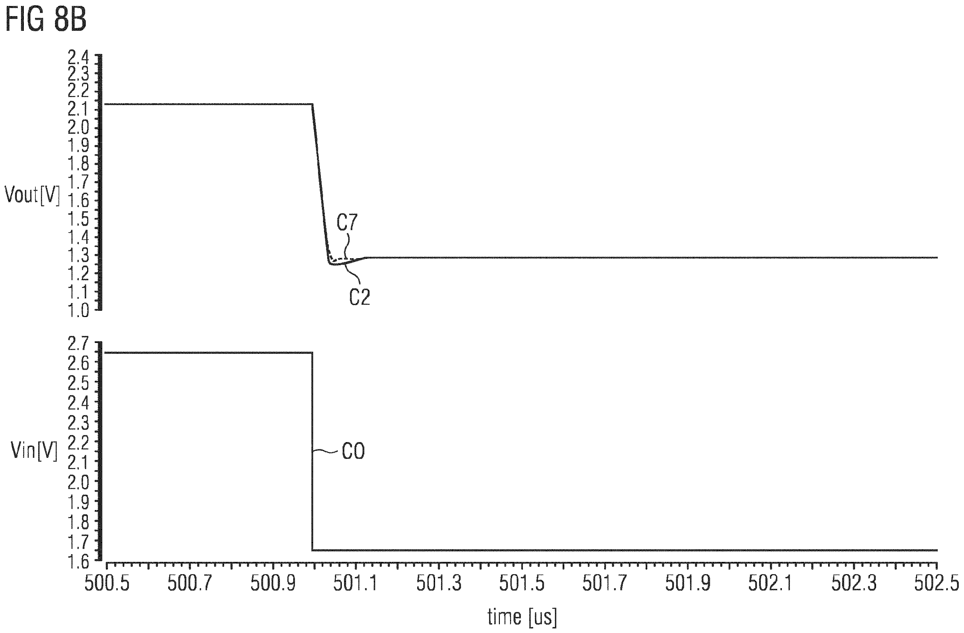

Figures 8a and 8b show the transient behaviour of the circuit arrangements. Figures 8a and 8b show the output voltages Vout of the above-mentioned embodiments versus time in the upper diagrams. The output voltages are step responses of an increasing input step C0 shown in the lower diagram of Figure 8a and a decreasing input step C0 shown in the lower diagram of Figure 8b. Curves C2 refer to the example shown in Figure 2 and curves C7 refer to the embodiment shown in Figure 7. The embodiment shown in Figure 2 has only a good pulldown capability; its pullup capability suffers from slew rate. Curve C7 clearly shows the improved step responses of the embodiment according to Figure 7 which has a faster response.

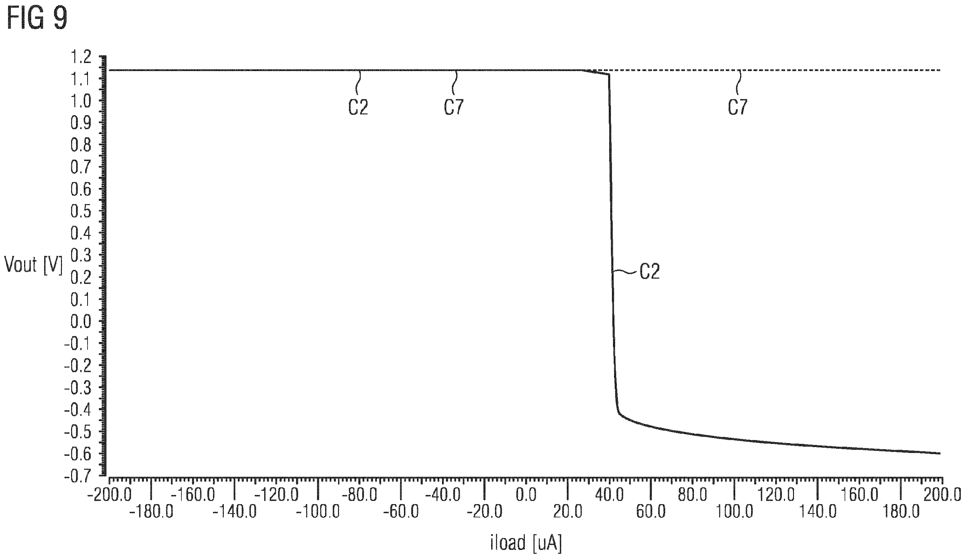

Figure 9 illustrates load regulation showing the output voltage Vout versus load current; the latter running from negative to positive values along the axis. Curve C2 refers to the example shown in Figure 2 and curve C7 refers to the embodiment shown in Figure 7. The embodiment in Figure 2 has only pulldown capability while the pullup current is limited to the bias current, which may be e.g. 17uA; the output voltage drops significantly afterwards. If the load current has positive values, the voltage will drop and cannot be regulated anymore. The embodiment according to Figure 7 is capable to drive a few milliampere of current in both directions under 1mV output voltage variation only.

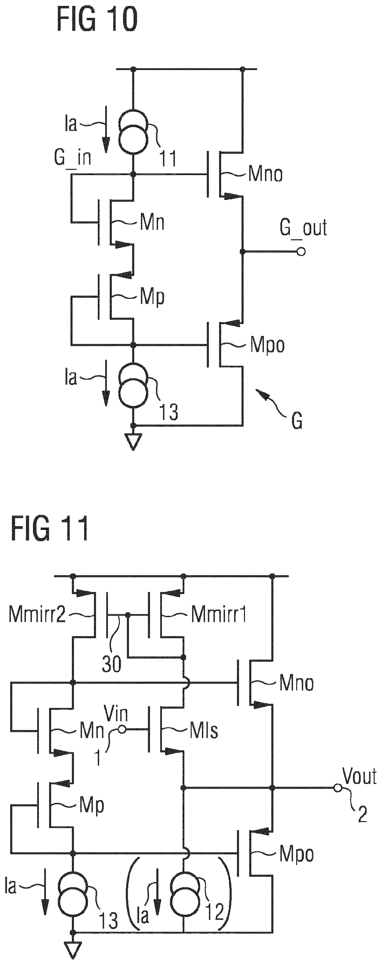

Figure 10 shows an alternative example of the amplifier including a push-pull structure having two complementary transistors.

The amplifier G comprises a first circuit branch including a first transistor Mno, being an NMOS, and a second transistor Mpo, being a PMOS, that are complementary transistors. A source terminal of the first transistor Mno is connected to a source terminal of the second transistor Mpo and an out terminal G_out. A second branch comprises a third transistor Mn, being an NMOS, and a fourth transistor Mp, being a PMOS, a source terminal of the third transistor Mn being connected to a source terminal of the fourth transistor Mp. The third and fourth transistors Mn, Mp are coupled between the first current source 11 and a further current source 13, both providing the same current Ia. A drain terminal of the third transistor Mn is connected to a gate terminal of the first and third transistors Mno, Mn and the amplifier input G_in. A drain terminal of the fourth transistor Mp is connected to a gate terminal of the second and fourth transistors Mpo, Mp. This amplifier G is a rather classic push-pull stage for class AB performance.

Figure 11 shows an example including the before-mentioned amplifier G. In order to avoid duplication, the arrangement of the amplifier G is not described again and only differences with respect to Figure 4 are mentioned.

The output terminal G_out which also serves as a circuit output 2 is connected to the source terminals of the first transistor Mno and the level shift NMOS Mls. Moreover, the input terminal G_in is coupled to the current source by means of a current mirror 30. Starting from Figure 10, the complete level shift structure is obtained after inserting the current mirror 30 including an NMOS pair Mmirr1, Mmirr2 at the amplifier input due to the need to ensure a negative sign to the feedback loop.

In other words, the first current source is embodied as mirror transistor Mmirr1, which is comprised by the current mirror 30 also comprising a further mirror transistor Mmirr2. A second current source 12 may be connected to the source terminal of the level shift NMOS Mls which provides a current Ia. The current is equal to the ones provided by the further current source 13 or the current mirror 30.

The whole level shift example is shown in Figure 11. Despite the presence of an NMOS diode Mmirr1 on its drain, the current across the level shift NMOS Mls is constant regardless of the loading conditions: The first and second transistors Mno and Mpo deliver large current in both directions after minor variations at their gate voltages. As soon as the current Ia generating source's and the mirror transistor's Mirr2 output impedances are large, the current across the mirror transistor Mmirr2 and consequently mirror transistor Mirror1 is forced to remain the same. In this way the voltage between gate and source terminals Vgs of the level shift NMOS Mls is made insensitive to the load current value and a low output impedance is provided even under extreme loading conditions. The drain is loaded by a MOSFET which mirrors the current into a fixed generator to ensure a constant channel current. The mirror output and the current generator summing node are the input of the push-pull stage that has an output G_out shorted to the level shift NMOS's Mls output formed by its source terminal.

It should be mentioned that the second current source 12 can be omitted if properly setting the ratio W/L for the second transistor Mpo.

**Reference numerals**

| | |
|---|---|
| 1 | circuit input |
| 2 | circuit input |
| 11, 12, 13, 14 | current source |
| 20, 30 | current mirror |
| G | amplifier |
| G_in | input terminal |
| G_out | output terminal |
| Mls, Mp, Mf, Mn, Md, Mn_ab, Mp_ab, Mr; M_up, M_down, Mno, Mpo, Mmirr1, Mmirr2 | transistor |
| Ia, Ib, If, Is, Ir | current |
| Vin, Vout, Vc, Vb_ab, Vin, Vgs | voltage |
| C0, C2, C7 | curve |

## Claims

1. Circuit arrangement comprising
- a circuit input (1),
- a circuit output (2),
- a first current source (11),
- a MOSFET (Mls) having a gate terminal, a source terminal and a drain terminal; the gate terminal being connected with the circuit input (1), the drain terminal being coupled with a terminal of the first current source (11);
- a push-pull amplifier (G) having an input terminal (G_in) and an output terminal (G_out), the input terminal (G_in) being coupled to the terminal of the first current source (11), the output terminal (G_out) being connected to the source terminal and the circuit output (2);
- wherein the push-pull amplifier (G) comprises
- in a first circuit branch a totem pole circuit including a first transistor (M_up) and a second transistor (M_down), a source terminal of the first transistor (M_up) being coupled to a drain terminal of the second transistor (M_down);
- a second circuit branch being connected in parallel to the first circuit branch, the second circuit branch comprising a third transistor (Mr) and a third current source (13) being connected to a drain terminal of the third transistor (Mr) and a gate terminal of the first transistor (M_up); and
- a third circuit branch comprising a fourth current source (14) and a fourth transistor (Mf), a drain terminal of the fourth transistor (Mf) being connected to the fourth current source (14) and the gate terminals of the second and third transistors (M _down, Mr);
wherein the input terminal (G_in) is connected to a source terminal of the fourth transistor (Mf) and the output terminal (G_out) being connected to the source terminal of the first transistor (M_up),
wherein if the MOSFET (Mls) is an NMOS, the first, second and third transistors (M_up, M_down, Mr) are NMOS transistors and the fourth transistor (Mf) is a PMOS and wherein if the MOSFET is an PMOS,
the first, second and third transistors (M_up, M_down, Mr) are PMOS transistors and the fourth transistor (Mf) is an NMOS.

2. Circuit arrangement according to claim 1
further comprising a second current source (12) connected to the source terminal.

3. Circuit arrangement according to claim 1 or 2,
wherein the MOSFET (Mls) is an NMOS.

4. Circuit arrangement according to any of the previous claims,
wherein the amplifier (G) is a class AB amplifier.

5. Circuit arrangement according to any of the previous claims ,
wherein the first, second, and third transistors (M_up, M_down, Mr) are NMOS.

## Patentansprüche

1. Schaltungsanordnung umfassend
- einen Schaltungseingang (1);
- einen Schaltungsausgang (2);
- eine erste Stromquelle (11);
- einen MOSFET (Mls) mit einem Gate-Anschluss, einem Source-Anschluss und einem Drain-Anschluss, wobei der Gate-Anschluss mit dem Schaltungseingang (1) verbunden ist und der Drain-Anschluss mit einem Anschluss der ersten Stromquelle (11) gekoppelt ist;
- einen Gegentaktverstärker (G) mit einem Eingangsanschluss (G_in) und einem Ausgangsanschluss (G_out), wobei der Eingangsanschluss (G_in) mit dem Anschluss der ersten Stromquelle (11) gekoppelt ist und der Ausgangsanschluss (G_out) mit dem Source-Anschluss und dem Schaltungsausgang (2) verbunden ist;
- wobei der Gegentaktverstärker (G) umfasst
- in einem ersten Schaltungszweig eine Totem-Pol-Schaltung mit einem ersten Transistor (M_up) und einem zweiten Transistor (M_down), wobei ein Source-Anschluss des ersten Transistors (M_up) mit einem Drain-Anschluss des zweiten Transistors (M_down) gekoppelt ist;
- einen zweiten Schaltungszweig, der parallel zu dem ersten Schaltungszweig geschaltet ist, wobei der zweite Schaltungszweig einen dritten Transistor (Mr) und eine dritte Stromquelle (13) umfasst, die mit einem Drain-Anschluss des dritten Transistors (Mr) und einem Gate-Anschluss des ersten Transistors (M_up) verbunden ist; und
- einen dritten Schaltungszweig mit einer vierten Stromquelle (14) und einem vierten Transistor (Mf), wobei ein Drain-Anschluss des vierten Transistors (Mf) mit der vierten Stromquelle (14) und den Gate-Anschlüssen des zweiten und dritten Transistors (M_down, Mr) verbunden ist;
- wobei der Eingangsanschluss (G_in) mit einem Source-Anschluss des vierten Transistors (Mf) verbunden ist und der Ausgangsanschluss (G_out) mit dem Source-Anschluss des ersten Transistors (M_up) verbunden ist,
- wobei, wenn der MOSFET (Mls) ein NMOS ist, der erste, zweite und dritte Transistor (M_up, M_down, Mr) NMOS-Transistoren sind und der vierte Transistor (Mf) ein PMOS ist, und wobei, wenn der MOSFET (Mls) ein PMOS ist, der erste, zweite und dritte Transistor (M_up, M_down, Mr) PMOS-Transistoren sind und der vierte Transistor (Mf) ein NMOS ist.

2. Schaltungsanordnung nach Anspruch 1, ferner umfassend eine zweite Stromquelle (12), die mit dem Source-Anschluss verbunden ist.

3. Schaltungsanordnung nach Anspruch 1 oder 2, wobei der MOSFET (Mls) ein NMOS ist.

4. Schaltungsanordnung nach einem der vorstehenden Ansprüche, wobei der Verstärker (G) ein Verstärker der Klasse AB ist.

5. Schaltungsanordnung nach einem der vorstehenden Ansprüche, wobei der erste, zweite und dritte Transistor (M_up, M_down, Mr) NMOS sind.

## Revendications

1. Agencement de circuit comprenant
- une entrée de circuit (1),
- une sortie de circuit (2),
- une première source de courant (11),
- un MOSFET (M1s) présentant une borne de grille, une borne de source et une borne de drain ; la borne de grille étant connectée à l'entrée de circuit (1), la borne de drain étant couplée à une borne de la première source de courant (11) ;
- un amplificateur push-pull (G) présentant une borne d'entrée (G_in) et une borne de sortie (G_out), la borne d'entrée (G_in) étant couplée à la borne de la première source de courant (11), la borne de sortie (G_out) étant connectée à la borne de source et à la sortie de circuit (2) ;
- sachant que l'amplificateur push-pull (G) comprend
- dans une première branche de circuit, un circuit à mât totémique incluant un premier transistor (M_up) et un deuxième transistor (M_down), une borne de source du premier transistor (M_up) étant couplée à une borne de drain du deuxième transistor (M_down) ;
- une deuxième branche de circuit qui est connectée en parallèle à la première branche de circuit, la deuxième branche de circuit comprenant un troisième transistor (Mr) et une troisième source de courant (13) qui est connectée à une borne de drain du troisième transistor (Mr) et une borne de grille du premier transistor (M_up) ; et
- une troisième branche de circuit comprenant une quatrième source de courant (14) et un quatrième transistor (Mf), une borne de drain du quatrième transistor (Mf) étant connectée à la quatrième source de courant (14) et aux bornes de grille du deuxième et du troisième transistor (M_down, Mr) ;
- sachant que la borne d'entrée (G_in) est connectée à une borne de source du quatrième transistor (Mf) et la borne de sortie (G_out) étant connectée à la borne de source du premier transistor (M_up),
- sachant que si le MOSFET (M1s) est un NMOS, le premier, le deuxième et le troisième transistor (M_up, M_down, Mr) sont des transistors NMOS et le quatrième transistor (Mf) est un PMOS et sachant que si le MOSFET est un PMOS, le premier, le deuxième et le troisième transistor (M_up, M_down, Mr) sont des transistors PMOS et le quatrième transistor (Mf) est un NMOS.

2. Agencement de circuit selon la revendication 1, comprenant en outre une deuxième source de courant (12) connectée à la borne de source.

3. Agencement de circuit selon la revendication 1 ou 2, sachant que le MOSFET (M1s) est un NMOS.

4. Agencement de circuit selon l'une quelconque des revendications précédentes, sachant que l'amplificateur (G) est un amplificateur de classe AB.

5. Agencement de circuit selon l'une quelconque des revendications précédentes, sachant que le premier, le deuxième et le troisième transistor (M_up, M_down, Mr) sont des NMOS.
